(19) **Europäisches Patentamt / European Patent Office / Office européen des brevets**

(11) **EP 1 208 650 B1**

(12) **EUROPEAN PATENT SPECIFICATION**

(45) Date of publication and mention
of the grant of the patent:
**27.02.2008 Bulletin 2008/09**

(21) Application number: **00958051.5**

(22) Date of filing: **01.09.2000**

(51) Int Cl.:
*H04B 1/04* (2006.01)    *H03D 7/16* (2006.01)

(86) International application number:
**PCT/CA2000/000994**

(87) International publication number:
**WO 2001/017120 (08.03.2001 Gazette 2001/10)**

(54) **FREQUENCY TRANSLATOR USING A NON-PERIODIC LOCAL OSCILLATOR SIGNAL**

FREQUENZUMSETZER UNTER VERWENDUNG EINES APERIODISCHEN
ÜBERLAGERUNGSOSZILLATORSIGNALS

PROCEDE ET APPAREIL AMELIORES DE CONVERSION NEGATIVE DE SIGNAUX DE
RADIOFREQUENCE (RF)

(84) Designated Contracting States:
**AT BE CH CY DE DK ES FI FR GB GR IE IT LI LU
MC NL PT SE**

(30) Priority: **01.09.1999 CA 2281236**

(43) Date of publication of application:
**29.05.2002 Bulletin 2002/22**

(73) Proprietor: **SiRiFIC Wireless Corporation
Waterloo, ON N2L 5J2 (CA)**

(72) Inventors:
• **MANKU, Tajinder
Kitchener, Ontario N2N 3K9 (CA)**

• **WONG, Lawrence
Markham, Ontario L3R 8V9 (CA)**
• **LING, Yang
Kitchener, Ontario K2E 1L6 (CA)**

(74) Representative: **Price, Nigel John King et al
J.A. Kemp & Co.
14 South Square
Gray's Inn
London WC1R 5JJ (GB)**

(56) References cited:
**EP-A- 0 899 868        WO-A-96/01006
GB-A- 2 329 085        US-A- 5 390 346**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

The present invention relates generally to communications, and more specifically, to a fully-integrable method and apparatus for down conversion of radio frequency (RF) signals with reduced local oscillator (LO) leakage and 1/f noise.

## Background of the Invention

Many communication systems modulate electromagnetic signals to higher frequencies for transmission, and subsequently demodulate those high frequencies back to their original frequency band when they reach the receiver. The original (or baseband) signal, may be, for example: data, voice or video. These baseband signals may be produced by transducers such as microphones or video cameras, be computer generated, or transferred from an electronic storage device.

All of these signals are generally referred to as radio frequency (RF) signals, which are electromagnetic signals, that is, waveforms with electrical and magnetic properties within the electromagnetic spectrum normally associated with radio wave propagation. The electromagnetic spectrum was traditionally divided into 26 alphabetically designated bands, however, the ITU formally recognizes 12 bands, from 30 Hz to 3000 GHz. New bands, from 3 THz to 3000 THz, are under active consideration for recognition.

Wired communication systems which employ such modulation and demodulation techniques include computer communication systems such as local area networks (LANs), point to point signalling, and wide area networks (WANs) such as the Internet. These networks generally communication data signals over electrical or optical fibre chanels. Wireless communication systems which may employ modulation and demodulation include those for public broadcasting such as AM and FM radio, and UHF and VHF television. Private communication systems may include cellular telephone networks, personal paging devices, HF radio systems used by taxi services, microwave backbone networks, interconnected appliances under the Bluetooth standard, and satellite communications. Other wired and wireless systems which use RF modulation and demodulation would be known to those skilled in the art.

One of the current problems in the art, is to develop physically small and inexpensive modulation and demodulation techniques and devices that have good performance characteristics. For cellular telephones, for example, it is desirable to have a receiver which can be fully integrated onto an integrated circuit.

Several attempts have been made at completely integrating communication receiver designs, but have met with limited degrees of success. Most RF receivers use the "super-heterodyne" topology, which provides good performance, but does not meet the desired level of integration for modern wireless systems. The super-heterodyne topology typically requires at least two high quality filters that cannot be economically integrated within any modern IC technology. Other RF receiver topologies exist, such as image rejection architectures, which can be completely integrated on a chip but lack in overall performance.

Existing solutions and their associated problems and limitations are summarized below:

## 1. Super-heterodyne:

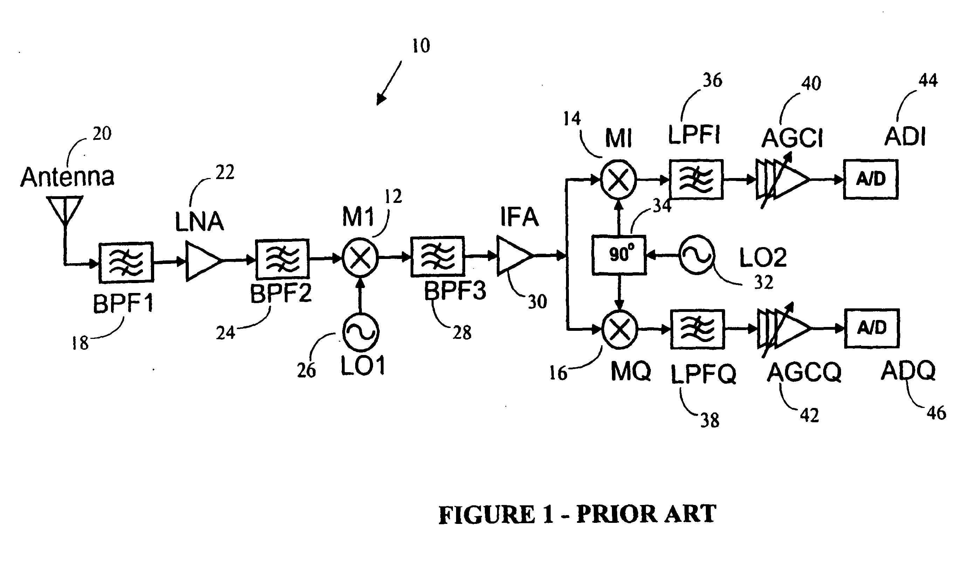

The super-heterodyne receiver uses a two-step frequency translation method to convert an RF signal to a baseband signal. **Figure 1** presents a block diagram of a typical super-heterodyne receiver **10**. The mixers labelled M1 **12**, MI **14**, and MQ **16** are used to translate the RF signal to baseband or to some intermediate frequency (IF). The balance of the components amplify the signal being processed and filter noise from it.

The RF band pass filter (BPF1) **18** first filters the signal coming from the antenna **20** (note that this band pass filter **18** may also be a duplexer). A low noise amplifier **22** then amplifies the filtered antenna signal, increasing the strength of the RF signal and reducing the noise figure of the receiver **10**. The signal is next filtered by another band pass filter (BPF2) **24** usually identified as an image rejection filter. The signal then enters mixer M1 **12** which multiplies the signal from the image rejection filter **24** with a periodic signal generated by the local oscillator (LO1) **26**. The mixer M1 **12** receives the signal from the image rejection filter **24** and translates it to a lower frequency, known as the first intermediate frequency (IF1).

Generally, a mixer is a circuit or device that accepts as its input two different frequencies and presents at its output:

(a)     a signal equal in frequency to the sum of the frequencies of the input signals;

(b)     a signal equal in frequency to the difference between the frequencies of the input signals; and

(c)     the original input frequencies.

The typical embodiment of a mixer is a digital switch which may have significantly more tones than stated above.

The IF1 signal is next filtered by a band pass filter (BPF3) **28** typically called the channel filter, which is centred around the IF1 frequency, thus filtering out mixer signals (a) and (c) above.

The signal is then amplified by an amplifier (IFA) **30,** and is split into its in-phase (I) and quadrature (Q) components, using mixers MI **14** and MQ **16**, and orthogonal signals generated by local oscillator (LO2) **32** and 90 degree phase shifter **34.** LO2 **32** generates a periodic signal which is typically tuned the IF1 frequency. The signals coming from the outputs of MI **14** and MQ **16** are now at baseband, that is, the frequency at which they were originally generated. The two signals are next filtered using low pass filters LPFI **36** and LPFQ **38** to remove the unwanted products of the mixing process, producing baseband I and Q signals. The signals may then be amplified by gain-controlled amplifiers AGCI **40** and AGCQ **42,** and digitized via analog to digital converters ADI **44** and ADQ **46** if required by the receiver.

The main problems with the super-heterodyne design are:

- it requires expensive off-chip components, particularly band pass filters **18, 24, 28,** and low pass filters **36, 38;**
- the off-chip components require design trade-offs that increase power consumption and reduce system gain;
- image rejection is limited by the off-chip components, not by the target integration technology;
- isolation from digital noise can be a problem; and
- it is not fully integratable.

### 2. Direct Conversion:

Direct conversion architectures demodulate RF signals to baseband in a single step, by mixing the RF signal with a local oscillator signal at the carrier frequency. There is therefore no image frequency, and no image components to corrupt the signal. Direct conversion receivers offer a high level of integratability, but also have several important problems. Hence, direct conversion receivers have thus far proved useful only for signalling formats that do not place appreciable signal energy near DC after conversion to baseband.

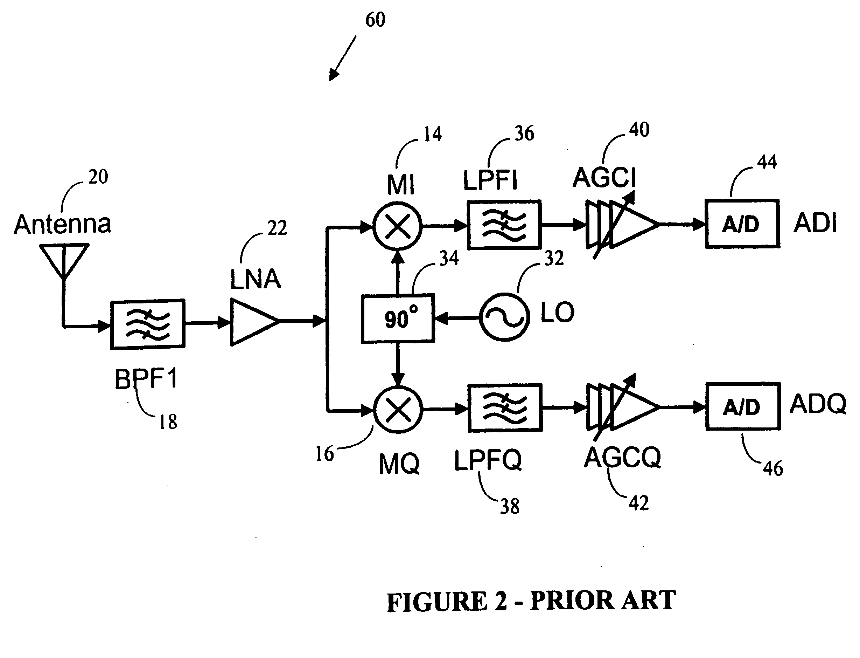

A typical direct conversion receiver is shown in **Figure 2.** The RF band pass filter (BPF1) **18** first filters the signal coming from the antenna **20** (this band pass filter **18** may also be a duplexer). A low noise amplifier **22** is then used to amplify the filtered antenna signal, increasing the strength of the RF signal and reducing the noise figure of the receiver **10.**

The signal is then split into its quadrature components using mixers MI **14** and MQ **16,** and orthogonal signals generated by local oscillator (LO2) **32** and 90 degree phase shifter **34.** LO2 **32** generates a periodic signal which is tuned the incoming wanted frequency rather than an IF frequency as in the case of the super-heterodyne receiver. The signals coming from the outputs of MI **14** and MQ **16** are now at baseband, that is, the frequency at which they were originally generated. The two signals are next filtered using low pass filters LPFI **36** and LPFQ **38,** are amplified by gain-controlled amplifiers AGCI **40** and AGCQ **42,** and are digitized via analog to digital converters ADI **44** and ADQ **46.**

Direct conversion RF receivers have several advantages over super-heterodyne systems in term of cost, power, and level of integration, however, there are also several serious problems with direct conversion. These problems include:

- noise near baseband (that is, 1/f noise) which corrupts the desired signal;
- local oscillator (LO) leakage in the RF path that creates DC offsets. As the LO frequency is the same as the incoming signal being demodulated, any leakage of the LO signal onto the antenna side of the mixer will pass through to the output side as well;
- local oscillator leakage into the RF path that causes desensitization. Desensitation is the reduction of desired signal gain as a result of receiver reaction to an undesired signal. The gain reduction is generally due to overload of some portion of the receiver, such as the AGC circuitry, resulting in suppression of the desired signal because the receiver will no longer respond linearly to incremental changes in input voltage.
- noise inherent to mixed-signal integrated circuits corrupts the desired signal;
- large on-chip capacitors are required to remove unwanted noise and signal energy near DC, which makes integrability expensive. These capacitors are typically placed between the mixers and the low pass filters; and
- errors are generated in the quadrature signals due to inaccuracies in the 90 degree phase shifter.

### 3. Image Rejection Architectures:

Several image rejection architectures exist, the two most well known being the Hartley Image Rejection Architecture and the Weaver Image Rejection Architecture. There are other designs, but they are generally based on these two architectures while some methods employ poly-phase filters to cancel image components. Generally, either accurate signal phase shifts or accurate generation of quadrature local oscillators are employed in these architectures to cancel the image frequencies. The amount of image cancellation is directly dependent upon the degree of accuracy in producing the phase shift or in producing the quadrature local oscillator signals.

Although the integratability of these architectures is high, their performance is relatively poor due to the required accuracy of the phase shifts and quadrature oscillators. This architecture has been used for dual mode receivers on a single chip.

### 4. Near Zero-IF Conversion:

This receiver architecture is similar to the direct conversion architecture, in that the RF band is brought close to baseband in a single step. However, the desired signal is not brought exactly to baseband and therefore DC offsets and 1/f noise do not contaminate the signal. Image frequencies are again a problem as in the super-heterodyne structure.

Additional problems encountered with near zero-IF architectures include:

■ the need for very accurate quadrature local oscillators; and
■ the need for several balanced signal paths for purposes of image cancellation.

### 5. Sub-sampling Downconversion:

This method of signal downconversion utilizes subsampling of the RF signal to cause the frequency translation. Although the level of integration possible with this technique is the highest among those discussed thus far, the subsampling downconversion method suffers from two major drawbacks:

■ subsampling of the RF signal causes aliasing of unwanted noise power to DC. Sampling by a factor of $m$ increases the downconverted noise power of the sampling circuit by a factor of $2m$; and
■ subsampling also increases the effect of noise in the sampling clock. In fact, the clock phase noise power is increased by $m^2$ for sampling by a factor of $m$.

### 6. Other Systems:

Three other related RF modulation systems are described in the Honeywell PCT Patent Application No. PCT/US95/08019, United States Patent Serial No. 5,390,346 awarded to Marz, and GEC Marconi's Patent Application No. 9719224.9, published as GB 2,329,085 A.

The Honeywell Patent Application No. PCT/US95/08019 describes a demodulation topology which is an extension of earlier super-heterodyne designs. This design allegedly rejects "spurious" signals which are defined on page 1 at lines 26 - 32, and again on page 6 at lines 17 -26 with respect to a specific example: when a 90MHz LO signal is used to demodulate a desired 80MHz signal, and there is a 100MHz "spurious" signal in the signal path, then both the desired signal and the spurious signal will demodulate to 10MHz. Honeywell explains that it is generally impossible to separate these two signals as they will overlap one another at 10MHz.

Honeywell proposes a two-stage mixing topology that demodulates the desired signal, but allegedly suppresses this spurious signal. They do this by using two local oscillators (LO) that one would see in a typical superheterodyne topology, except that the two LO signals are modulated with the same spread spectrum (SS) pattern before they are mixed with the input signal.

They argue that the desired 80MHz signal will be encoded by the first SS LO, and then decoded by the second. They also argue that the 100MHz will not be properly decoded by the second SS LO, so this signal would simply remain as noise at the output (lines 20 - 21 of page 6 read: "In other words, the desired signal is correctly spread in the bandwidth but the undesired signal is not." At lines 25 - 26 of page 6, Honeywell then notes: "... the desired signal may be recovered since it is spread differently from the undesired signal.")

The Honeywell design does nothing to suppress noise that arrives at the input to the first mixer, whether it is spurious, local oscillator leakage, or any other signal. Any signal received at the input to the first mixer will be encoded by the first SS signal, and then decoded by the second SS signal; at the same time being downconverted by the two LO signals on the two mixers.

United States Patent Serial No. 5,390,346 awarded to Marz describes a two-stage superheteroyne topology in which two local oscillator signals are generated using programmable, wideband synthesizers. Marz argues that it is desirable to effect small changes in the output frequency of the down-converter, by means of large changes in the frequencies of the two mixing signals. Such a system requires complex and expensive filters and LO synthesizers, and could not be fully integrated. As well, the Marz system does nothing to address the problems of LO leakage in down-conversion.

GEC Marconi's Patent Application No. 9719224.9 describes an RF transmitter amplifier which uses feedback loops to reduce DC offsets. However, the general design is completely unrelated to those encountered in the design of down-converters. Furthermore, the signals being handled and manipulated with the feedback loops of the GEC Marconi patent are completely different from those which would be encountered in the design of a down-conversion circuit.

There is therefore a need for a method and apparatus of demodulating RF signals which allows the desired integrability along with good performance.

**Summary of the Invention**

It is therefore an object of the invention to provide a novel method and system of modulation which obviates or mitigates at least one of the disadvantages of the prior art.

According to one aspect of the invention there is provided a radio frequency (RF) down-convertor with reduced local oscillator leakage, for emulating the demodulation of an input signal $x(t)$ with a local oscillator signal having frequency $f$, said down-convertor comprising:

a synthesizer for generating mixing signals $\varphi_1$ and $\varphi_2$ which vary irregularly over time, where:

$\varphi_1 * \varphi_2$ has significant power at the frequency $f$ of said local oscillator signal being emulated;
neither $\varphi_1$ nor $\varphi_2$ has significant power at the frequency $f$ of said local oscillator signal being emulated; and
said mixing signals $\varphi_1$ and $\varphi_2$ are designed to emulate said local oscillator signal having frequency $f$, in a time domain analysis;
a first mixer coupled to said synthesizer for mixing said input signal $x(t)$ with said mixing signal $\varphi_1$ to generate an output signal $x(t)\,\varphi_1$; and
a second mixer coupled to said synthesizer and to the output of said first mixer for mixing said signal $x(t)\,\varphi_1$ with said mixing signal $\varphi_2$ to generate an output signal $x(t)\,\varphi_1\,\varphi_2$, said output signal $x(t)\,\varphi_1\,\varphi_2$ emulating the modulation of said input signal $x(t)$ with said local oscillator signal having frequency $f$, characterized in that:

said synthesizer uses a single time base to generate both mixing signals $\varphi_1$ and $\varphi_2$.

**Brief Description of the Drawings**

These and other features of the invention will become more apparent from the following description in which reference is made to the appended drawings in which:

| | |
|---|---|
| **Figure 1** | presents a block diagram of a super-heterodyne system as known in the art; |
| **Figure 2** | presents a block diagram of a direct conversion or homodyne system as known in the art; |
| **Figure 3 (a)** | presents a block diagram of a broad implementation of the invention; |
| **Figure 3 (b)** | presents exemplary mixer input signals functions $\varphi_1$ and $\varphi_2$ plotted in amplitude against time; |
| **Figure 4** | presents a block diagram of quadrature demodulation in an embodiment of the invention; |
| **Figure 5** | presents a block diagram of an embodiment of the invention employing error correction by measuring the amount of power at baseband; |
| **Figure 6** | presents a block diagram of a receiver in a preferred embodiment of the invention; |
| **Figure 7** | presents a block diagram of an embodiment of the invention employing a filter placed between mixers M1 and M2; and |
| **Figure 8** | presents a block diagram of an embodiment of the invention employing N mixers and N mixing signals. |

**Detailed Description of Preferred Embodiments of the Invention**

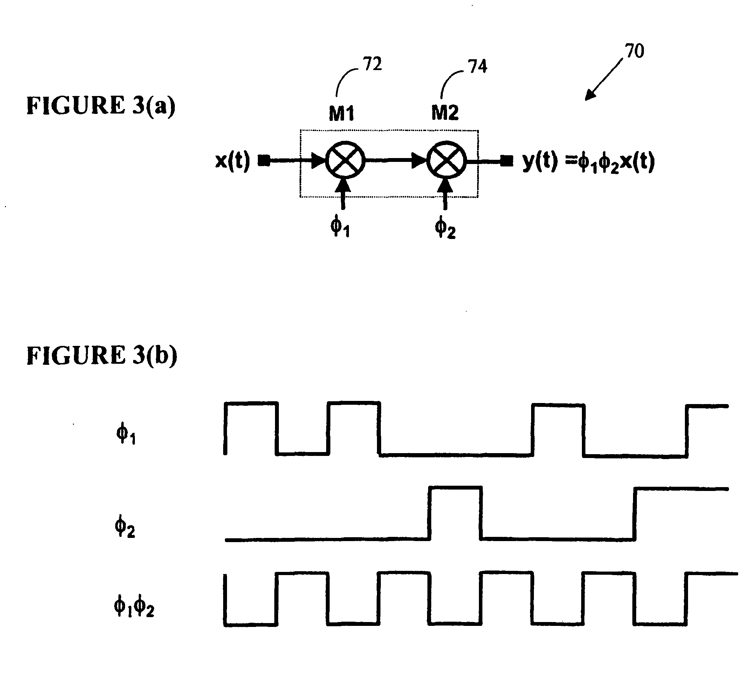

A device which addresses the objects outlined above, is presented as a block diagram in **Figure 3(a).** This figure presents a demodulator topography **70** in which an input signal $x(t)$ is mixed with signals which are irregular in the time domain (TD), which effect the desired demodulation. A virtual local oscillator (VLO) is generated by multiplying two functions (labelled $\varphi_1$ and $\varphi_2$) within the signal path of the input signal $x(t)$ using two mixers M1 **72** and M2 **74.** The mixers described within this invention would have the typical properties of mixers within the art, that is, they would have an associated noise figure, linearity response, and conversion gain. The selection and design of these mixers would follow the standards known in the art, and could be, for example, double balanced mixers. Though this figure implies various elements are implemented in analogue form they can be implemented in digital form.

The two time-varying functions $\varphi_1$ and $\varphi_2$ that comprise the virtual local oscillator (VLO) signal have the property that their product is equal to the local oscillator (LO) being emulated, however, neither of the two signals has a significant level of power at the frequency of the local oscillator being emulated. As a result, the desired demodulation is affected, but there is no LO signal to leak in the RF path. **Figure 3b** depicts possible functions for $\varphi_1$, and $\varphi_2$.

To minimize the leakage of LO power into the RF signal, as in the case of direct conversion receivers, the preferred criteria for selecting the functions $\varphi_1$ and $\varphi_2$ are:

(i) that $\varphi_1$ and $\varphi_2$ do not have any significant amount of power at the carrier frequency. That is, the amount of power generated at the carrier frequency should not effect the overall system performance of the receiver in a significant manner;

(ii) the signals required to generate $\varphi_1$ and $\varphi_2$ should not have a significant amount of power at the RF carrier frequency; and

(iii) if x(t) is an RF signal, $\varphi_1$ $\varphi_1$ $\varphi_2$ should not have a significant amount of power within the bandwidth of the RF signal at baseband.

Conditions (i) and (ii) ensure an insignificant amount of power is generated within the system at the carrier frequencies which would cause an equivalent LO leakage problem found in conventional direct conversion topologies. Condition (iii) ensures that if $\varphi_1$ leaks into the input port, it does not produce a signal within the baseband signal at the output.

Various functions can satisfy the conditions provided above, several of which are described hereinafter, however it would be clear to one skilled in the art that other similar pairs of signals may also be generated. These signals can in general be random, pseudo-random, periodic functions of time, or digital waveforms. As well, rather than employing two signals as shown above, sets of three or more may be used (additional description of this is given hereinafter).

It would also be clear to one skilled in the art that TD signals may be generated which provide the benefits of the invention to greater or lesser degrees. While it is possible in certain circumstances to have almost no leakage, it may be acceptable in other circumstances to incorporate virtual LO signals which still allow a degree of LO leakage.

It is also important to note that in order to reduce the 1/f noise commonly found in direct conversion receivers, the significant frequency components of $\varphi_2$ should be at a lower frequency than the frequency components of the function $\varphi_1$.

The topology of the invention is similar to that of direct conversion, but provides a fundamental advantage: minimal leakage of a local oscillator (LO) signal into the RF band. The topology also provides technical advantages over dual conversion topologies such as super-heterodyne systems:

• removes the necessity of having a second LO and various filters; and

• has a higher level of integration as the components it does require are easily placed on an integrated circuit.

While the basic implementation of the invention may produce errors in generating the virtual local oscillator (VLO), solutions to this problem are available and are described hereinafter.

The invention provides the basis for a fully integrated communications receiver. Increasing levels of integration have been the driving impetus towards lower cost, higher volume, higher reliability and lower power consumer electronics since the inception of the integrated circuit. This invention will enable communications receivers to follow the same integration route that other consumer electronic products have benefited from.

Specifically, advantages from the perspective of the manufacturers when incorporating the invention into a product include:

1. significant cost savings due to the decreased parts count of an integral device. Decreasing the parts count reduces the cost of inventory control, reduces the costs associated with warehousing components, and reduces the amount of manpower to deal with higher part counts;

2. significant cost savings due to the decreased manufacturing complexity. Reducing the complexity reduces time to market, cost of equipment to manufacture the product, cost of testing and correcting defects, and reduces time delays due to errors and problems on the assembly line;

3. reduces design costs due to the simplified architecture. The simplified architecture will shorten the first-pass design time and total design cycle time as a simplified design will reduce the number of design iterations required;

4. significant space savings and increased manufacturability due to the high integrability and resulting reduction in product form factor (physical size). This implies huge savings throughout the manufacturing process as smaller device footprints enable manufacturing of products with less material such as printed circuit substrate, smaller product casing and smaller final product packaging;

5. simplification and integrability of the invention will yield products with higher reliability, greater yield, less complexity, higher life span and greater robustness;

6. due to the aforementioned cost savings, the invention will enable the creation of products that would otherwise be economically unfeasible;

Hence, the invention provides the manufacturer with a significant competitive advantage.

From the perspective of the consumer, the marketable advantages of the invention include:

1. lower cost products, due to the lower cost of manufacturing;
2. higher reliability as higher integration levels and lower parts counts imply products will be less prone to damage from shock, vibration and mechanical stress;
3. higher integration levels and lower parts counts imply longer product life span;
4. lower power requirements and therefore lower operating costs;
5. higher integration levels and lower parts counts imply lighter weight products;
6. higher integration levels and lower parts counts imply physically smaller products; and
7. the creation of economical new products.

The present invention relates to the translation of an RF signal directly to baseband and is particular concerned with solving the LO-leakage problem and the 1/f noise problems associated with the present art. The invention allows one to fully integrate a RF receiver on a single chip without using external filters. Furthermore the RF receiver can be used as a multi-standard receiver. Descriptions of such exemplary embodiments follow.

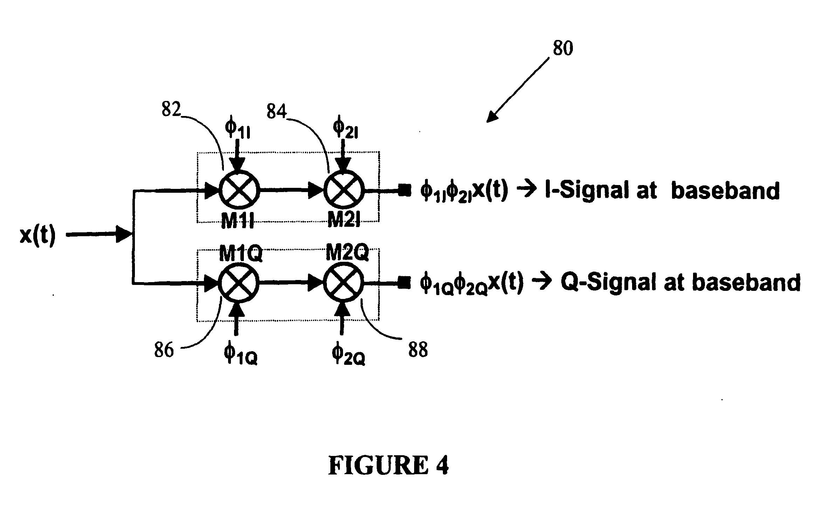

In many modulation schemes, it is necessary to demodulate both I and Q components of the input signal, which requires a demodulator 80 as presented in the block diagram of **Figure 4**. In this case, four demodulation functions would have to be generated: $\varphi_{1I}$ which is 90 degrees out of phase with $\varphi_{1Q}$; and $\varphi_{2I}$ which is 90 degrees out of phase with $\varphi_{2Q}$. The pairing of $\varphi_{1I}$ and $\varphi_{2I}$ must meet the function selection criteria listed above, as must the pairing of $\varphi_{1Q}$ and $\varphi_{2Q}$. The mixers **82**, **84**, **86**, **88** are standard mixers as known in the art.

As shown in **Figure 4**, mixer M1I **82** receives the input signal $x(t)$ and demodulates it with $\varphi_{1I}$; subsequent to this, mixer M2I **84** demodulates signal $x(t)\,\varphi_{1I}$ with $\varphi_{2I}$ to yield the in-phase component of the input signal at baseband, that is, $x(t)\,\varphi_{1I}\,\varphi_{2I}$. A complementary process occurs on the quadrature side of the demodulator, where mixer M1Q **86** receives the input signal $x(t)$ and demodulates it with $\varphi_{1Q}$; after which mixer M2Q **88** demodulates signal $x(t)\,\varphi_{1Q}$ with $\varphi_{2Q}$ to yield the quadrature phase component of the input signal at baseband, that is, $x(t)\,\varphi_{1Q}\,\varphi_{2Q}$. Generation of appropriate $\varphi_{1I}$, $\varphi_{2I}$, $\varphi_{1Q}$ and $\varphi_{2Q}$ signals would be clear to one skilled in the art from the teachings herein.

In the analysis above timing errors that would arise when constructing the *VLO* have been neglected (timing errors can be in the form of a delay or a mismatch in rise/fall times. In the analysis which follows, only delays are considered, but the same analysis can be applied to rise/fall times. The actual *VLO* that is generated can be written as:

$$VLO_a = VLO_i + \varepsilon_{vlo}(t) \qquad\qquad (1)$$

where $VLO_a$ is the actual *VLO* generated, $VLO_I$ is the ideal *VLO* without any timing error, and $\varepsilon_{VLO}(t)$ absorbs the error due to timing errors. Therefore, the output signal of the virtual LO topology, denoted as $y(t)$, becomes:

$$y(t) = x(t) \times [VLO_i + \varepsilon_{vlo}(t)] \qquad\qquad (2)$$

The term $x(t)\,VLO_i$ is the wanted term and $x(t)\,\varepsilon_{VLO}(t)$ is a term that produces aliasing power into the wanted signal. The term $\varepsilon_{VLO}(t)$ can also be thought of a term that raises the noise floor of the *VLO*. This term would produce in-band aliasing with power in the order of $\overline{\varepsilon_{vlo}}^2$, which is directly related to the bandwidth of the RF signal divided by the unity current gain frequency of the IC technology it is implemented in; assuming the worst-case scenario. This may be a serious problem for some applications. However, by selecting $\varphi_1$ and $\varphi_2$ carefully and by placing an appropriate filter at the input of the structure, the amount of aliasing power can be reduced significantly, though it can never be completely eliminated due to timing errors.

There are several ways one could further reduce the amount of aliasing power, for example, by using a closed loop configuration as described below. The term $x(t)\,\varepsilon_{VLO}(t)$ contains two terms at baseband:

(i) aliasing power $P_a$, and
(ii) power of the wanted signal, but at a reduced power level which is on the order of delay error $P_{w\varepsilon}$.

Therefore, the total power at base-band (denoted by $P_M$) can be decomposed into three components:

(i) the power of the wanted signal, $P_w$,

(ii) the power of the aliasing terms, $P_a$, and

(iii) the power of the wanted signal arising from the term, $P_{w\varepsilon}$ (this power can either be positive or negative). Therefore,

$$P_M = P_w + P_{w\varepsilon}(\tau) + P_a(\tau) \qquad (3)$$

Note that $P_{w\varepsilon}$ and $P_a$ are a function of the delay $\tau$. Since $|P_w| >> |P_{w\varepsilon}|$, (3) becomes,

$$P_M = P_w + P_a(\tau) \qquad (4)$$

If the power, $P_M$ is measured and r is adjusted in time, one can reduce the term Pa to zero (or close to zero). Mathematically this can be done if the slope of $P_M$ with the delay r is set to zero; that is:

$$\frac{dP_M}{d\tau} = \frac{dP_a(\tau)}{d\tau} = 0 \qquad (5)$$

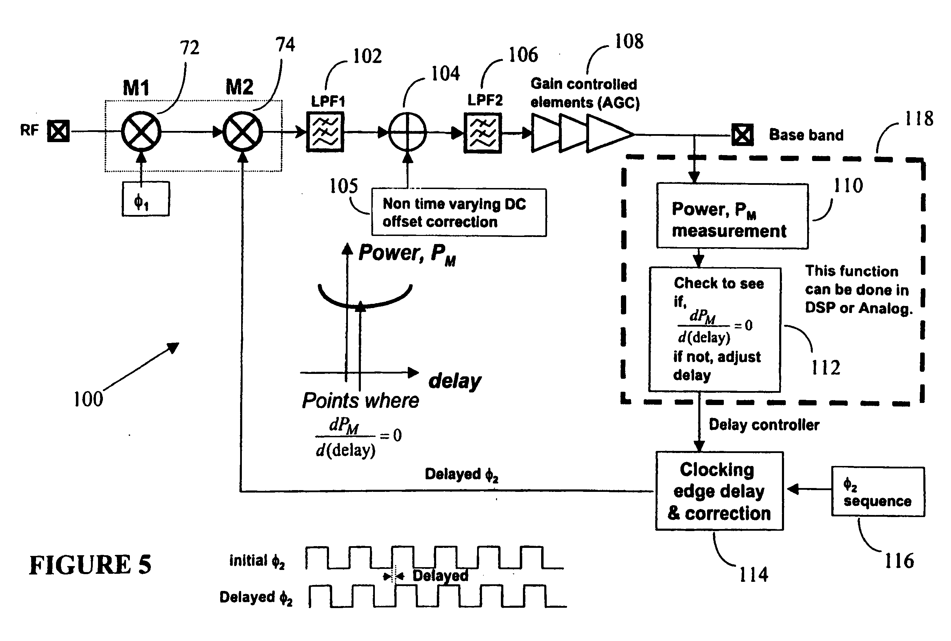

A system diagram of this procedure is illustrated in **Figure 5** (a more detailed description is provided in the paragraph below). The power measurement scheme and the element blocks required to detect when $\dfrac{dP_M}{d\tau} = 0$, can be implemented within a digital signal processing unit (DSP). Also illustrated in **Figure 5** is a visual representation of the power measured versus delay, which identifies an optimum point at which $\dfrac{dP_M}{d\tau} = 0$.

In the block diagram of **Figure 5** the RF signal is first multiplied by the signals $\varphi_1$ and $\varphi_2$ via mixers M1 **72** and M2 **74**, respectively. The signal is next filtered via a low pass filter (LPF) **102**, which is used to reduce the amount of out of band power, which may cause the subsequent elements to compress in gain or distort the wanted signal. The design of this LPF **102**, which may also be a band pass filter, depends on the bandwidth of the wanted signal.

Any DC offset is subsequently removed using a technique known in the art, such as a summer **104** and an appropriate DC offset source **105**. The signal is then filtered with LPF2 **106**, which provides further filtering of the base-band signal. The design of this filter depends on the system specifications and system design trade offs. The signal is then amplified using automatic gain control elements (AGC) **108** which provide a significant amount of gain to the filtered baseband signal. The design of AGC **108** depends on the system specifications and system design trade offs.

The physical order (that is, arrangement) of the two LPFs **102, 106**, the DC offset correction **104**, and the gain control elements **108** can be rearranged to some degree. Such modifications would be clear to one skilled in the art.

The baseband signal power is then measured with power measurement unit **110**. The power is minimized with respect to the delay added onto the signal $\varphi_2$ by use of the $\dfrac{dP_M}{d(delay)} = 0$ detector **112**, and the delay controller **114** which manipulates the $\varphi_2$ source **116**. In general, the power can be minimized with respect to the rise time of $\varphi_2$ or a combination of delay and rise time. Furthermore, the power can be minimized with respect to the delay, rise time, or both delay and rise time of the signal $\varphi_1$, or both $\varphi_1$, and $\varphi_2$.

It would be clear to one skilled in the art that current or voltage may be measured rather than power in certain applications. As well, the phase delay of either or both of $\varphi_1$ and $\varphi_2$ may be modified to minimized the error.

It is preferred that this power measurement **110** and detection **112** be done within a digital signal processing unit (DSP) **118** after the baseband signal is digitized via an analog to digital converter, but it may be done with separate components, or analogue components.

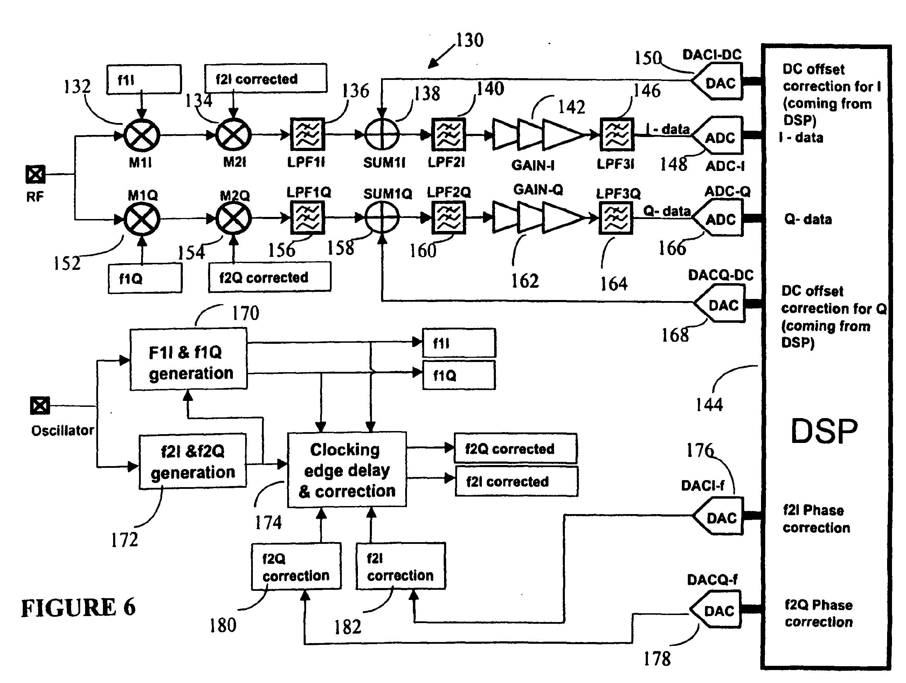

**Figure 6** presents a complete system block diagram of the preferred embodiment of the timing corrected apparatus of the invention **130**, handling in-phase and quadrature components of the input signal. Though the figure implies the use of analogue components, they can be implemented in digital form.

The front end which produces the filtered and amplified baseband signal is the same as that of **Figure 5,** except that two channels are used, one for in-phase and one for the quadrature component, as in **Figure 4.** Hence, components **132, 134, 136, 138, 140** and **142** of **Figure 6** correspond with components **72, 74, 102, 104, 106** and **108** of **Figure 5** respectively. The input signals to these components are slightly different, as the components of **Figure 6** are required to suit the in-phase component of the input signal. For example, the input to mixer **132** is a suitable in-phase $\varphi_1 I$ signal, such as that input to mixer M1I **82** of **Figure 4**, and the input to mixer 134 is a suitable in-phase signal $\varphi_2 I$ similar to that input to mixer M2I **84** of **Figure 4** which has been corrected for delay using the technique of **Figure 5.** A description of components for generating these two input signals follows hereinafter.

Two additional differences between the front end of the preferred embodiment of **Figure 6** and other embodiments described herein are:

- the generation of the DC offset signal for the summer **138** using the DSP **144** and a digital to analogue convertor (DAC) **150** (compare with the DC offset summer **104** and DC offset source **105** of **Figure 5);** and
- the addition of a third low pass filter LPF3I **146,** the de-aliasing filter for the analogue to digital convertor (ADC) **148** that follows. The design of this **LPF3I 146** depends on the system specifications and design.

The design of the front end for the quadrature-phase of the input signal follows in the same manner, with components **152, 154, 156, 158, 160, 162, 164, 166** and **168** complementary to components **132, 134, 136, 138, 140, 142, 146, 148** and **150,** respectively. The input signals to these components are also quuadrature-phase complements to the in-phase signal inputs.

It is preferred to generate the inputs to the four mixers **132, 134, 152, 154** in the manner presented in **Figure 6.** Specifically, the $\varphi_1 I$ and $\varphi_1 Q$ generation block **170** generates signals $\varphi_1 I$ and $\varphi_1 Q$, while $\varphi_2 I$ and $\varphi_2 Q$ generation block **172** generates signals $\varphi_2 I$ and $\varphi_2 Q$. The input to these generation blocks **170, 172** is an oscillator which does not have a significant amount of signal power at the frequency of the RF signal. The construction of the necessary logic for these components would be clear to one skilled in the art from the description herein, and in particular, with reference to **Figure 3.** Such signals may be generated using basic logic gates, field programmable gate arrays (FPGA), read only memories (ROMs), microcontrollers or other devices known in the art. Further description and other means of generating such signals is presented in the co-pending patent application under the Patent Cooperation Treaty, Serial No. PCT/CAD0/00996

Note that the outputs of the $\varphi_1 I$ and $\varphi_1 Q$ generation block **170** go directly to mixers **132** and **152,** and also to the clocking edge delay and correction block **174** which corrects the $\varphi_2 I$ and $\varphi_2 Q$ signals. The clocking edge delay and correction block **174** also receives I and Q output control signals from the DSP **144,** which are digitized by DAC **176** and **178,** and are time corrected at blocks **180** and **182.** Correction blocks **180** and **182** modify the digitized signals from DAC **176** and **178** as required to suit the clocking edge delay and correction block **174.** There also may be a connection between the $\varphi_1 I$ and $\varphi_1 Q$ generation block **170** and the $\varphi_2 I$ and $\varphi_2 Q$ generation block **172** which may be required where $\varphi_1 I$ and $\varphi_1 Q$ are generated using signals $\varphi_2 I$ and $\varphi_2 Q$. Of course, this control line may also pass in the opposite direction.

In the exemplary system of **Figure 6,** the calculation of the power is done within the DSP unit and a correction signal is generated. The method for correcting the error in the LO signal has been described with respect to **Figure 5.**

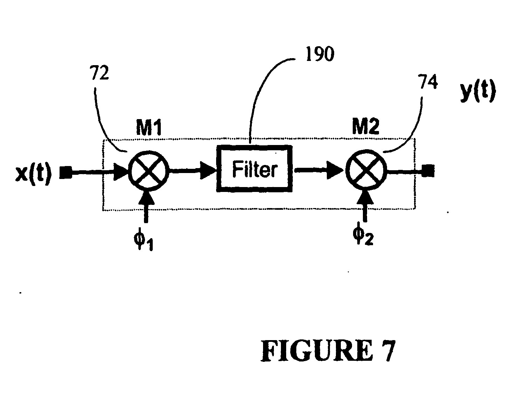

One variation to the basic structure in **Figure 3a** is to add a filter **190** between the two mixers **72, 74** as shown in the block diagram of **Figure 7** to remove unwanted signals that are transferred to the output port. This filter **190** may be a low pass, high pass, or band pass filter depending on the receiver requirements. The filter **190** does not necessarily have to be a purely passive filter, that is, it can have active components.

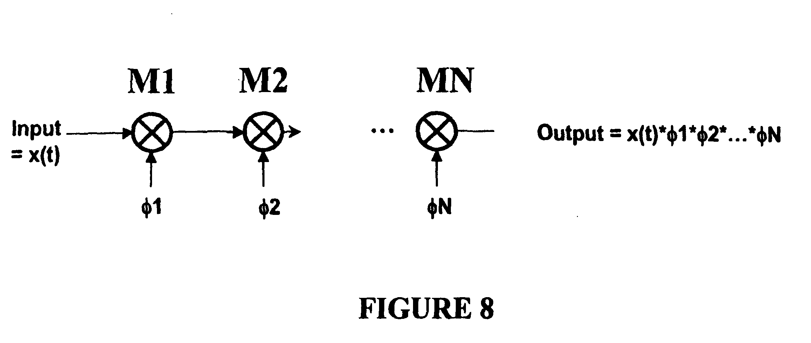

Another variation is that several functions $\varphi_1, \varphi_2, \varphi_3 ... \varphi_n$ may be used to generate the virtual LO, as presented in the block diagram of **Figure 8.** Here, $\varphi_1* \varphi_2*... *\varphi_n$ has a significant power level at the LO frequency, but each of the functions $\varphi_1... \varphi_n$ contain an insignificant power level at LO.

The electrical circuits of the invention may be described by computer software code in a simulation language, or hardware development language used to fabricate integrated circuits. This computer software code may be stored in a variety of formats on various electronic memory media including computer diskettes, CD-ROM, Random Access Memory (RAM) and Read Only Memory (ROM). As well, electronic signals representing such computer software code may also be transmitted via a communication network.

Clearly, such computer software code may also be integrated with the code of other programs, implemented as a core or subroutine by external program calls, or by other techniques known in the art.

The embodiments of the invention may be implemented on various families of integrated circuit technologies using digital signal processors (DSPs), microcontrollers, microprocessors, field programmable gate arrays (FPGAs), or discrete components. Such implementations would be clear to one skilled in the art.

The invention may be applied to various communication protocols and formats including: amplitude modulation (AM), frequency modulation (FM), frequency shift keying (FSK), phase shift keying (PSK), cellular telephone systems including analogue and digital systems such as code division multiple access (CDMA), time division multiple access (TDMA) and frequency division multiple access (FDMA).

The invention may be applied to such applications as wired communication systems include computer communication systems such as local area networks (LANs), point to point signalling, and wide area networks (WANs) such as the Internet, using electrical or optical fibre cable systems. As well, wireless communication systems may include those for public broadcasting such as AM and FM radio, and UHF and VHF television; or those for private communication such as cellular telephones, personal paging devices, wireless local loops, monitoring of homes by utility companies, cordless telephones including the digital cordless European telecommunication (DECT) standard, mobile radio systems, GSM and AMPS cellular telephones, microwave backbone networks, interconnected appliances under the Bluetooth standard, and satellite communications.

While particular embodiments of the present invention have been shown and described, it is clear that changes and modifications may be made to such embodiments without departing from the true scope and spirit of the invention.

**Claims**

1. A radio frequency (RF) down-convertor (100) with reduced local oscillator leakage, for emulating the demodulation of an input signal $x(t)$ with a local oscillator signal having frequency $f$, said down-convertor comprising:

   a synthesizer for generating mixing signals $\varphi_1$ and $\varphi_2$ which vary irregularly over time, where:

   $\varphi_1 * \varphi_2$ has significant power at the frequency $f$ of said local oscillator signal being emulated;
   neither $\varphi_1$ nor $\varphi_2$ has significant power at the frequency $f$ of said local oscillator signal being emulated; and
   said mixing signals $\varphi_1$ and $\varphi_2$ are designed to emulate said local oscillator signal having frequency $f$, in a time domain analysis;
   a first mixer (72) coupled to said synthesizer for mixing said input signal $x(t)$ with said mixing signal $\varphi_1$ to generate an output signal $x(t) \varphi_1$; and
   a second mixer (74) coupled to said synthesizer and to the output of said first mixer (72) for mixing said signal $x(t) \varphi_1$ with said mixing signal $\varphi_2$ to generate an output signal $x(t) \varphi_1 \varphi_2$, said output signal $x(t) \varphi_1 \varphi_2$ emulating the demodulation of said input signal $x(t)$ with said local oscillator signal having frequency $f$, **characterized in that**:

   said synthesizer uses a single time base to generate both mixing signals $\varphi_1$ and $\varphi_2$.

2. The radio frequency (RF) down-convertor (100) of claim 1 wherein said synthesizer is further operable to generate mixing signals $\varphi_1$ and $\varphi_2$, such that the product $\varphi_1 * \varphi_1 * \varphi_2$ will not result in a significant amount of power within the bandwidth of an input signal that the down-converter is designed to down-convert to baseband.

3. The radio frequency (RF) down-convertor (100) of claim 2, further comprising:

   a DC offset correction circuit (104,105).

4. The radio frequency (RF) down-convertor (100) of claim 3, wherein said DC offset correction circuit comprises:

   a DC source having a DC output (105); and
   a summer (104) for adding said DC output to an output of one of said mixers.

5. The radio frequency (RF) down-convertor (100) of claim 2, further comprising:

   a closed loop error correction circuit (118,114).

6. The radio frequency (RF) down-convertor (100) of claim 5, wherein said closed loop error correction circuit further comprises:

   an error level measurement circuit (118) and
   a time-varying signal modification circuit (114) for modifying a parameter of one of said mixing signals $\varphi_1$, and $\varphi_2$ to minimize said error level.

7. The radio frequency (RF) down-convertor (100) of claim 6, wherein said error level measurement circuit (118) comprises a power measurement (110).

8. The radio frequency (RF) down-convertor of claim 6, wherein said error level measurement circuit (118) comprises a voltage measurement.

9. The radio frequency (RF) down-convertor (100) of claim 6, wherein said error level measurement circuit (118) comprises a current measurement.

10. The radio frequency (RF) down-convertor (100) of claim 6, wherein said modified parameter is the phase delay of one of said mixing signals $\varphi_1$ and $\varphi_2$.

11. The radio frequency (RF) down-convertor (100) of claim 6, wherein said modified parameter is the fall or rise time of one of said mixing signals $\varphi_1$ and $\varphi_2$.

12. The radio frequency (RF) down-convertor (100) of claim 6, wherein said modified parameter includes both the phase delay and the fall or rise time of one of said mixing signals $\varphi_1$ and $\varphi_2$.

13. The radio frequency (RF) down-convertor (100) of claim 2 wherein said synthesizer further comprises:

   a synthesizer for generating mixing signals $\varphi_1$ and $\varphi_2$, where said mixing signals $\varphi_1$ and $\varphi_2$ can change with time in order to reduce errors.

14. The radio frequency (RF) down-convertor (100) of claim 1, further comprising:

   a filter (190) for removing unwanted signal components from said $x(t)$ $\varphi_1$ signal.

15. The radio frequency (RF) down-convertor (100) of claim 1, wherein said mixing signal $\varphi_2$ is a square wave.

16. The radio frequency (RF) down-convertor (100) of claim 1, wherein said mixing signals $\varphi_1$ and $\varphi_2$ effect the modulation of an in-phase component of said input signal $x(t)$, and a complementary up-convertor with mixing signals 90 degrees out of phase, is used to effect the modulation of a quadrature component of said input signal $x(t)$.

17. The radio frequency (RF) down-convertor (100) of claim 1, wherein said mixing signals $\varphi_1$ and $\varphi_2$ are irregular.

18. The radio frequency (RF) down-convertor (100) of claim 1, wherein said mixing signals $\varphi_1$ and $\varphi_2$ are digital waveforms.

19. The radio frequency (RF) down-convertor (100) of claim 1, wherein said mixing signals $\varphi_1$ and $\varphi_2$ are square waveforms.

20. The radio frequency (RF) down-convertor (100) of claim 1, further comprising:

   a local oscillator coupled to said synthesizer for providing a signal having a frequency that is an integral multiple of the desired mixing frequency.

21. The radio frequency (RF) down-convertor (100) of claim 1, where said synthesizer uses different patterns to generate signals $\varphi_1$ and $\varphi_2$.

22. A method of demodulating a radio frequency (RF) signal $x(t)$ with reduced local oscillator leakage comprising the steps of:

   generating mixing signals $\varphi_1$ and $\varphi_2$ which vary irregularly over time, where:

   $\varphi_1 * \varphi_2$ has significant power at the frequency $f$ of a local oscillator signal being emulated;
   neither $\varphi_1$ nor $\varphi_2$ has significant power at the frequency $f$ of said local oscillator signal being emulated; and
   said mixing signals $\varphi_1$ and $\varphi_2$ are designed to emulate said local oscillator signal having frequency $f$, in a time domain analysis;

mixing said input signal $x(t)$ with said mixing signal $\varphi_1$ to generate an output signal $x(t)$ $\varphi_1$; and
mixing said signal $x(t)$ $\varphi_1$ with said mixing signal $\varphi_2$ to generate an output signal $x(t)$ $\varphi_1$ $\varphi_2$, **characterised in that**
said mixing signals $\varphi_1$ and $\varphi_2$ are generated using a single time base.

23. An integrated circuit comprising the radio frequency (RF) down-convertor (100) of any one of claims 1 - 21.

24. A computer readable memory medium, storing computer software code in a hardware development language for fabrication of an integrated circuit comprising the radio frequency (RF) down-convertor (100) of any one of claims 1 - 21.

25. A computer data signal embodied in a carrier wave, said computer data signal comprising computer software code in a hardware development language for fabrication of an integrated circuit comprising the radio frequency (RF) down-convertor (100) of any one of claims 1 - 21.

**Patentansprüche**

1. Hochfrequenz-Abwärtswandler (100) mit reduziertem Empfängeroszillator-Restsignalanteil, zum Emulieren der Demodulation eines Eingangssignals x(t) mit einem Empfängeroszillatorsignal mit einer Frequenz f, welcher Abwärtswandler umfasst:

   einen Synthesizer zum Erzeugen von Mischsignalen $\varphi_1$ und $\varphi_2$, die sich über die Zeit unregelmäßig ändern, wobei:

   $\varphi_1$ * $\varphi_2$ eine erhebliche Leistung bei der Frequenz f des gerade emulierten Empfängeroszillatorsignals aufweist;
   weder $\varphi_1$ noch $\varphi_2$ eine erhebliche Leistung bei der Frequenz f des gerade emulierten Empfängeroszillatorsignals aufweisen; und
   die Mischsignale $\varphi_1$ und $\varphi_2$ ausgelegt sind, um das Empfängeroszillatorsignal mit der Frequenz f in einer Zeitdomänen-Analyse zu emulieren;
   einen ersten Mischer (72), der mit dem Synthesizer verbunden ist, um das Eingangssignal x(t) mit dem Mischsignal $\varphi_1$ zu mischen, um ein Ausgangssignal x(t) $\varphi_1$ zu erzeugen; und
   einen zweiten Mischer (74), der mit dem Synthesizer und dem Ausgang des ersten Mischers (72) verbunden ist, um das Signal x(t) $\varphi_1$ mit dem Mischsignal $\varphi_2$ zu mischen, um ein Ausgangssignal x(t) $\varphi_1$ $\varphi_2$ zu erzeugen, wobei das Ausgangssignal x(t) $\varphi_1$ $\varphi_2$, das die Demodulation des Eingangssignals x(t) mit dem Empfängeroszillatorsignal emuliert, eine Frequenz f aufweist, **dadurch gekennzeichnet, dass**:

   der Synthesizer eine einzige Zeitbasis verwendet, um beide Mischsignale $\varphi_1$ und $\varphi_2$ zu erzeugen.

2. Hochfrequenz-Abwärtswandler nach Anspruch 1, wobei der Synthesizer außerdem betreibbar ist, um Mischsignale $\varphi_1$ und $\varphi_2$ zu erzeugen, so dass das Produkt $\varphi_1$ * $\varphi_2$ nicht in einem erheblichen Leistungsanteil innerhalb der Bandbreite eines Eingangssignals resultieren wird, für dessen Abwärtswandlung in ein Basisband der Abwärtswandler ausgelegt ist.

3. Hochfrequenz-Abwärtswandler (100) nach Anspruch 2, weiterhin umfassend:

   eine Gleichstrom-Offset-Korrekturschaltung (104, 105).

4. Hochfrequenz-Abwärtswandler (100) nach Anspruch 3, wobei die Gleichstrom-Offset-Korrekturschaltung umfasst:

   eine Gleichstromquelle mit einem Gleichstrom-Ausgang (105); und
   einen Summierer (104), um das Gleichstrom-Ausgangssignal zu einem Ausgangssignal von einem der Mischer zu addieren.

5. Hochfrequenz-Abwärtswandler (100) nach Anspruch 2, weiterhin umfassend: eine Fehler-Regelungskorrekturschaltung (118, 114).

6. Hochfrequenz-Abwärtswandler (100) nach Anspruch 5, wobei die Fehler-Regelungskorrekturschaltung außerdem umfasst:

   eine Fehler-Signalmessschaltung (119) und
   eine zeitlich veränderliche Signalmodifizierungsschaltung (114), um einen Parameter von einem der Mischsignale $\varphi_1$ und $\varphi_2$ zu modifizieren, um das Fehlersignal zu minimieren.

7. Hochfrequenz-Abwärtswandler (100) nach Anspruch 6, wobei die Fehlersignal-Messschaltung (118) eine Leistungsmessung (110) umfasst.

8. Hochfrequenz-Abwärtswandler nach Anspruch 6, wobei die Fehlersignal-Messschaltung (118) eine Spannungsmessung umfasst.

9. Hochfrequenz-Abwärtswandler (100) nach Anspruch 6, wobei die Fehlersignal-Messschaltung (118) eine Strommessung umfasst.

10. Hochfrequenz-Abwärtswandler (100) nach Anspruch 6, wobei der modifizierte Parameter die Phasenverzögerung von einem der Mischsignale $\varphi_1$ und $\varphi_2$ darstellt.

11. Hochfrequenz-Abwärtswandler (100) nach Anspruch 6, wobei der modifizierte Parameter die Anstiegs- oder Abfallzeit von einem der Mischsignale $\varphi_1$ und $\varphi_2$ ist.

12. Hochfrequenz-Abwärtswandler (100) nach Anspruch 6, wobei der modifizierte Parameter sowohl die Phasenverzögerung als auch die Anstiegs- oder Abfallzeit von einem der Mischsignale $\varphi_1$ und $\varphi_2$ umfasst.

13. Hochfrequenz-Abwärtswandler (100) nach Anspruch 2, wobei der Synthesizer außerdem umfasst:

   einen Synthesizer, um Mischsignale $\varphi_1$ und $\varphi_2$ zu erzeugen, wobei die Mischsignale $\varphi_1$ und $\varphi_2$ sich mit der Zeit ändern können, um Fehler zu reduzieren.

14. Hochfrequenz-Abwärtswandler (100) nach Anspruch 1, weiterhin umfassend:

   einen Filter (190), um unerwünschte Signalkomponenten aus dem Signal x(t) $\varphi_1$ zu entfernen.

15. Hochfrequenz-Abwärtswandler (100) nach Anspruch 1, wobei das Mischsignal $\varphi_2$ ein Rechtecksignal ist.

16. Hochfrequenz-Abwärtswandler (100) nach Anspruch 1, wobei die Mischsignale $\varphi_1$ und $\varphi_2$ die Modulation einer gleichphasigen Komponente des Eingangssignals x(t) beeinflussen, und wobei ein komplementärer Aufwärtswandler mit Mischsignalen, die um 90° außer Phase sind, dazu verwendet wird, um die Modulation einer Quadratur-Komponente des Eingangssignals x(t) zu beeinflussen.

17. Radiofrequenz-Abwärtswandler (100) nach Anspruch 1, wobei die Mischsignale $\varphi_1$ und $\varphi_2$ unregelmäßig sind.

18. Hochfrequenz-Abwärtswandler (100) nach Anspruch 1, wobei die Mischsignale $\varphi_1$ und $\varphi_2$ digitale Signale sind.

19. Hochfrequenz-Abwärtswandler (100) nach Anspruch 1, wobei die Mischsignale $\varphi_1$ und $\varphi_2$ Rechtecksignale sind.

20. Hochfrequenz-Abwärtswandler (100) weiterhin umfassend:

   einen Empfängeroszillator, der mit dem Synthesizer verbunden ist, um ein Signal mit einer Frequenz bereitzustellen, die ein ganzzahliges Vielfaches der gewünschten Mischfrequenz ist.

21. Hochfrequenz-Abwärtswandler (100) nach Anspruch 1, wobei der Synthesizer unterschiedliche Muster verwendet, um Signale $\varphi_1$, und $\varphi_2$ zu erzeugen.

22. Verfahren zum Demodulieren eines Hochfrequenzsignals x(t) mit reduziertem Empfängeroszillator-Restsignalanteil, mit den Schritten:

Erzeugen von Mischsignalen $\varphi_1$ und $\varphi_2$, die sich mit der Zeit unregelmäßig verändern, wobei:

$\varphi_1$ * $\varphi_2$ eine erhebliche Leistung bei der Frequenz f des gerade emulierten Empfängeroszillatorsignals aufweisen;

weder $\varphi_1$ noch $\varphi_2$ eine erhebliche Leistung bei der Frequenz f des gerade emulierten Empfängeroszillatorsignals aufweist; und

die Mischsignale $\varphi_1$ und $\varphi_2$ ausgelegt sind, um das Empfängeroszillatorsignal mit der Frequenz f in einer Zeitdomänen-Analyse zu emulieren;

Mischen des Eingangssignals x(t) mit dem Mischsignal $\varphi_1$, um ein Ausgangssignal x(t) $\varphi_1$, zu erzeugen; und

Mischen des Signals x(t) $\varphi_1$ mit dem Mischsignal $\varphi_2$, um ein Ausgangssignal x(t) $\varphi_1$, $\varphi_2$ zu erzeugen, **dadurch gekennzeichnet, dass**

die Mischsignale $\varphi_1$ und $\varphi_2$ unter Verwendung einer einigen Zeitbasis erzeugt werden.

23. Integrierte Schaltung, umfassend den Hochfrequenz-Abwärtswandler (100) nach einem der Ansprüche 1-21.

24. Computerlesbares Speichermedium, das einen Computersoftwarecode in einer Hardwareentwicklungssprache speichert, zur Herstellung einer integrierten Schaltung, die einen Höchfrequenz-Abwärtswandler (100) nach einem der Ansprüche 1-21 umfasst.

25. Computerdatensignal in Form eines Trägersignals, wobei das Computerdatensignal einen Computersoftwarecode in einer Hardwareentwicklungssprache umfasst, zur Herstellung einer integrierten Schaltung, die den Hochfrequenz-Abwärtswandler (100) nach einem der Ansprüche 1-21 umfasst.

## Revendications

1. Convertisseur abaisseur (100) de radiofréquence (RF) avec une fuite d'oscillateur local réduite, pour émuler la démodulation d'un signal d'entrée $x(t)$ avec un signal d'oscillateur local ayant une fréquence $f$, ledit Convertisseur abaisseur comprenant :

un synthétiseur pour générer des signaux de mélange $\varphi_1$ et $\varphi_2$ qui varient de façon irrégulière dans le temps, où :

$\varphi_1$ * $\varphi_2$ a une puissance significative à la fréquence f dudit signal d'oscillateur local émulé ;

ni $\varphi_1$ ni $\varphi_2$ n'ont une puissance significative à la fréquence $f$ dudit signal d'oscillateur local émulé ; et

lesdits signaux de mélange $\varphi_1$ et $\varphi_2$ sont conçus pour émuler ledit signal d'oscillateur local ayant la fréquence $f$, dans une analyse de domaine temporel ;

un premier mélangeur (72) couplé audit synthétiseur pour mélanger ledit signal d'entrée $x(t)$ audit signal de mélange $\varphi_1$ pour générer un signal de sortie $x(t)$ $\varphi_1$ ; et

un second mélangeur (74) couplé audit synthétiseur et à la sortie dudit premier mélangeur (72) pour mélanger ledit signal $x(t)$ $\varphi_1$ audit signal de mélange $\varphi_2$ pour générer un signal de sortie $x(t)$ $\varphi_1$ $\varphi_2$, ledit signal de sortie $x(t)$ $\varphi_1$ $\varphi_2$ émulant la démodulation dudit signal d'entrée $x(t)$ avec ledit signal d'oscillateur local ayant la fréquence $f_1$ **caractérisé en ce que** :

ledit synthétiseur utilise une base de temps unique pour générer les deux signaux de mélange $\varphi_1$ et $\varphi_2$.

2. Convertisseur abaisseur (100) de radiofréquence (RF) selon la revendication 1, dans lequel ledit synthétiseur est en outre opérationnel pour générer des signaux de mélange $\varphi_1$ et $\varphi_2$, de sorte que le produit $\varphi_1$ * $\varphi_1$ * $\varphi_2$ n'a pas pour résultat une quantité significative de puissance à l'intérieur de la bande passante d'un signal d'entrée que le convertisseur abaisseur doit convertir en bande de base en en abaissant la fréquence.

3. Convertisseur abaisseur (100) de radiofréquence (RF) selon la revendication 2, comprenant en outre :

un circuit de correction de décalage de courant continu (104, 105).

4. Convertisseur abaisseur (100) de radiofréquence (RF) selon la revendication 3, dans lequel ledit circuit de correction de décalage de courant continu comprend :

une source de courant continu ayant une sortie de courant continu (105) ; et

un additionneur (104) pour ajouter ladite sortie de courant continu à la sortie d'un desdits mélangeurs.

5.  Convertisseur abaisseur (100) de radio fréquence (RF) selon la revendication 2, comprenant en outre :

    un circuit de correction d'erreur à boucle fermée (118, 114).

6.  Convertisseur abaisseur (100) de radiofréquence (RF) selon la revendication 5, dans lequel ledit circuit de correction d'erreur à boucle fermée comprend en outre :

    un circuit de mesure de niveau d'erreur (118) et
    un circuit de modification de signal variant temporellement (114) pour modifier un paramètre d'un desdits signaux de mélange $\varphi_1$ et
    $\varphi_2$ pour minimiser ledit niveau d'erreur.

7.  Convertisseur abaisseur (100) de radiofréquence (RF) selon la revendication 6, dans lequel ledit circuit de mesure de niveau d'erreur (118) comprend une mesure de puissance (110).

8.  Convertisseur abaisseur de radiofréquence (RF) selon la revendication 6, dans lequel ledit circuit de mesure de niveau d'erreur (118) comprend une mesure de tension.

9.  Convertisseur abaisseur (100) de radiofréquence (RF) selon la revendication 6, dans lequel ledit circuit de mesure de niveau d'erreur (118) comprend une mesure de courant.

10. Convertisseur abaisseur (100) de radiofréquence (RF) selon la revendication 6, dans lequel ledit paramètre modifié est le retard de phase d'un desdits signaux de mélange $\varphi_1$ et $\varphi_2$.

11. Convertisseur abaisseur (100) de radiofréquence (RF) selon la revendication 6, dans lequel le dit paramètre modifié est le temps de descente ou le temps de montée d'un desdits signaux de mélange $\varphi_1$ et $\varphi_2$.

12. Convertisseur abaisseur (100) de radiofréquence (RF) selon la revendication 6, dans lequel ledit paramètre modifié comprend aussi bien le retard de phase que le temps de descente ou de montée d'un desdits signaux de mélange $\varphi_1$ et $\varphi_2$.

13. Convertisseur abaisseur (100) de radiofréquence (RF) selon la revendication 2, dans lequel ledit synthétiseur comprend en outre :

    un synthétiseur pour générer des signaux de mélange $\varphi_1$ et $\varphi_2$, lesdits signaux de mélange $\varphi_1$ et $\varphi_2$ pouvant changer dans le temps afin de réduire les erreurs.

14. Convertisseur abaisseur (100) de radiofréquence (RF) selon la revendication 1, comprenant en outre :

    un filtre (190) pour retirer des composantes de signal non désirées dudit signal $x(t)$ $\varphi_1$.

15. Convertisseur abaisseur (100) de radiofréquence (RF) selon la revendication 1, dans lequel ledit signal de mélange $\varphi_2$ est une onde carrée.

16. Convertisseur abaisseur (100) de radiofréquence (RF) selon la revendication 1, dans lequel lesdits signaux de mélange $\varphi_1$ et $\varphi_2$ effectuent la modulation d'une composante en phase dudit signal d'entrée $x(t)$, et un convertisseur élévateur complémentaire avec des signaux de mélange déphasés de 90 degrés est utilisé pour effectuer la modulation de la composante de quadrature dudit signal d'entrée $x(t)$.

17. Convertisseur abaisseur (100) de radiofréquence (RF) selon la revendication 1, dans lequel lesdits signaux de mélange $\varphi_1$ et $\varphi_2$ sont irréguliers.

18. Convertisseur abaisseur (100) de radiofréquence (RF) selon la revendication 1, dans lequel lesdits signaux de mélange $\varphi_1$ et $\varphi_2$ ont des formes d'ondes numériques.

19. Convertisseur abaisseur (100) de radiofréquence (RF) selon la revendication 1, dans lequel lesdits signaux de

mélange $\varphi_1$ et $\varphi_2$ ont des formes d'ondes carrées.

20. Convertisseur abaisseur (100) de radiofréquence (RF) selon la revendication 1, comprenant en outre :

un oscillateur local couplé audit synthétiseur pour former un signal ayant une fréquence qui est un multiple entier de la fréquence de mélange désirée.

21. Convertisseur abaisseur (100) de radiofréquence (RF) selon la revendication 1, dans lequel ledit synthétiseur utilise différents modèles pour générer les signaux $\varphi_1$ et $\varphi_2$.

22. Procédé de démodulation de signal $x(t)$ de radiofréquence (RF) avec une fuite d'oscillateur local réduite comprenant les étapes de :

générer des signaux de mélange $\varphi_1$ et $\varphi_2$ qui varient de façon irrégulière dans le temps, où :

$\varphi_1$ * $\varphi_2$ a une puissance significative à la fréquence $f$ d'un signal d'oscillateur local émulé ;
ni $\varphi_1$ ni $\varphi_2$ n'ont une puissance significative à la fréquence $f$ dudit signal d'oscillateur local émulé ; et
lesdits signaux de mélange $\varphi_1$ et $\varphi_2$ sont conçus pour émuler ledit signal d'oscillateur local ayant la fréquence $f$, dans une analyse de domaine temporel ;
mélanger ledit signal d'entrée $x(t)$ avec ledit signal de mélange $\varphi_1$ pour générer un signal de sortie $x(t)\varphi_1$ ; et
mélanger ledit signal $x(t)\varphi_1$ avec ledit signal de mélange $\varphi_2$ pour générer un signal de sortie $x(t)\varphi_1\varphi_2$, **caractérisé en ce que**
lesdits signaux de mélange $\varphi_1$ et $\varphi_2$ sont générés à l'aide d'une base de temps unique.

23. Circuit intégré comprenant le convertisseur abaisseur (100) de radiofréquence (RF) selon l'une quelconque des revendications 1 à 21.

24. Support de mémoire lisible par ordinateur stockant un code de logiciel informatique dans un langage de développement de matériel pour la fabrication un circuit intégré comprenant le convertisseur abaisseur (100) de radiofréquence (RF) selon l'une quelconque des revendications 1 à 21.

25. Signal de données informatiques intégré dans une onde porteuse, ledit signal de données informatiques comprenant un code de logiciel informatique dans un langage de développement de matériel pour la fabrication d'un circuit intégré comprenant le convertisseur abaisseur (100) de radiofréquence (RF) selon l'une quelconque des revendications 1 à 21.

**FIGURE 1 - PRIOR ART**

EP 1 208 650 B1

**FIGURE 2 - PRIOR ART**

EP 1 208 650 B1

FIGURE 3(a)

$$y(t) = \phi_1\phi_2 x(t)$$

FIGURE 3(b)

$\phi_{1I}\phi_{2I}x(t) \rightarrow$ I-Signal at  baseband

$\phi_{1Q}\phi_{2Q}x(t) \rightarrow$ Q-Signal at baseband

**FIGURE 4**

FIGURE 5

EP 1 208 650 B1

**FIGURE 6**

**FIGURE 7**

**M1**   **M2**   **MN**

Input ——→ ⊗ ——→ ⊗ ——→   ···   ⊗ ———   Output = x(t)*φ1*φ2*...*φN
= x(t)

φ1        φ2                    φN

**FIGURE 8**

**EP 1 208 650 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9508019 W
- US 5390346 A, Marz
- US 9719224 B
- GB 2329085 A